# EUROPEAN PATENT APPLICATION

(11) **EP 4 667 615 A2**
(43) Date of publication of application: **24.12.2025**
(21) Application number: 25176838.8
(22) Date of filing: 15.05.2025
(51) Int. Cl.: C23C 14/04, C23C 14/22, C23C 14/24, H10K 71/16

(54) **DEPOSITION SOURCE AND DEPOSITION APPARATUS INCLUDING THE SAME**

(30) Priority: 28.05.2024 KR 20240069530
(71) Applicant: Samsung Display Co., Ltd., Yongin-si Gyeonggi-do 17113 (KR)
(72) Inventor: LEE, Jin Yong, Yongin-si, Gyeonggi-do 17084 (KR); YU, Kyong Tae, Yongin-si, Gyeonggi-do 17084 (KR)
(74) Representative: Marks & Clerk LLP

(57) **Abstract**

A deposition source includes a crucible accommodating a deposition material and having an open top, a cover plate covering the open top of the crucible, a deposition nozzle disposed on the cover plate, where the deposition nozzle discharges the deposition material, a support plate extending upwardly from the cover plate, and an angle limiter disposed on the support plate. An angle-limiting hole, through which the deposition material passes, is defined in the angle limiter, and a first line extending from one side of the deposition nozzle to a top of the angle-limiting hole is longer than a second line extending from the one side of the deposition nozzle to a point where an imaginary line extending from one side of the angle-limiting hole to the cover plate and an imaginary line extending from the one side of the deposition nozzle parallel to the cover plate meet each other.

## Description

### BACKGROUND

### 1. Field

The disclosure relates to a deposition source and a deposition apparatus including the deposition source.

### 2. Description of the Related Art

An organic light-emitting display device is a display device that utilizes a phenomenon where electrons injected from a cathode and holes injected from an anode recombine in an organic thin film to generate excitons, and light of a particular wavelength is generated from the energy of the generated excitons.

For the organic light-emitting display device, a vacuum deposition method can be employed to deposit organic materials or metals used as electrodes onto a substrate. The vacuum deposition method typically includes placing a substrate for forming an organic thin film within a vacuum chamber, closely attaching a mask assembly with a pattern identical to a thin film to be formed onto the substrate, and then evaporating or sublimating a deposition material, such as an organic material, using a deposition source to deposit it onto the substrate.

The deposition source may include a deposition nozzle and a crucible that accommodates the deposition material. As the crucible is heated, the deposition material vaporizes and can be emitted through the deposition nozzle. An angle limiter may be positioned above the deposition nozzle to control the emission angle of the deposition material released through the deposition nozzle.

### SUMMARY

Embodiments of the disclosure provide a deposition source and a deposition apparatus including the deposition source, which can maintain a high incidence angle of a deposition material onto a deposition substrate and ensure the uniformity of the deposition material deposited on the deposition substrate.

However, embodiments of the disclosure are not restricted to those set forth herein. The above and other features of embodiments of the disclosure will become more apparent to one of ordinary skill in the art to which the disclosure pertains by referencing the detailed description of the disclosure given below.

According to an embodiment of the disclosure, a deposition source includes a crucible accommodating a deposition material and having an open top, a cover plate covering the open top of the crucible, a deposition nozzle disposed on an upper surface of the cover plate, where the deposition nozzle discharges the deposition material, a support plate extending upwardly from the cover plate, and an angle limiter disposed on the support plate, where an emission angle of the deposition material discharged from the deposition nozzle is restricted by the angle limiter, where an angle-limiting hole, through which the deposition material passes, is defined in the angle limiter and a first line extending from one side of the deposition nozzle in a first direction to a top of the angle-limiting hole is longer than a second line extending from the one side of the deposition nozzle in the first direction to a point where an imaginary line extending from one side of the angle-limiting hole in the first direction to the cover plate and an imaginary line extending from the one side of the deposition nozzle in the first direction parallel to the cover plate meet each other.

In an embodiment, the first line may be perpendicular to the cover plate, and the second line may be parallel to the cover plate.

In an embodiment, the first line may be at least five times longer than the second line.

In an embodiment, an angle between the second line and a third line extending from the one side of the deposition nozzle in the first direction to the one side of the angle-limiting hole in the first direction may be about 80° or greater.

In an embodiment, the deposition nozzle may be provided in plural, and a plurality of deposition nozzles may be arranged in a second direction intersecting the first direction.

In an embodiment, the plurality of deposition nozzles may be divided into multiple groups, and a distance between the plurality of deposition nozzles in each of the multiple groups may be smaller than a distance between adjacent groups among the multiple groups.

In an embodiment, the angle limiter may be provided in plural, and a plurality of angle limiters may be arranged in the second direction in a way such that angle-limiting holes of the plurality of angle limiters are located above the multiple groups.

According to an embodiment of the disclosure, a deposition source includes a crucible accommodating a deposition material and having an open top, a cover plate covering the open top of the crucible, a deposition nozzle disposed on an upper surface of the cover plate, where the deposition nozzle discharges the deposition material, a support plate extending upwardly from the cover plate, and an angle limiter disposed on the support plate, wherein an emission angle of the deposition material discharged from the deposition nozzle is restricted by the angle limiter, where an angle-limiting hole, through which the deposition material passes, is defined in the angle limiter, and an angle between an imaginary line extending from one side of the deposition nozzle in a first direction to one side of the angle-limiting hole in the first direction and an imaginary line parallel to the cover plate is greater than an angle between an imaginary line extending from the one side of the deposition nozzle in the first direction to an opposite side of the angle-limiting hole in the first direction and the imaginary line parallel to the cover plate.

In an embodiment, the angle between the imaginary line extending from the one side of the deposition nozzle in the first direction to the one side of the angle-limiting hole in the first direction and the imaginary line parallel to the cover plate may be about 80° or greater.

In an embodiment, the angle between the imaginary line extending from the one side of the deposition nozzle in the first direction to the opposite side of the angle-limiting hole in the first direction and the imaginary line parallel to the cover plate may be about 80° or greater.

In an embodiment, the deposition nozzle may be provided in plural, and a plurality of deposition nozzles may be arranged in the first direction and a second direction intersecting the first direction.

In an embodiment, the plurality of deposition nozzles may be divided into multiple groups, and a distance between the plurality of deposition nozzles in each of the multiple groups is smaller than a distance between adjacent groups among the multiple groups.

In an embodiment, the angle limiter may be provided in plural, and a plurality of angle limiters may be arranged in the second direction in a way such that angle-limiting holes of the plurality of angle limiters are located above the groups.

In an embodiment, the crucible may be provided in plural, and a plurality of crucibles may include a first crucible accommodating a first deposition material and a second crucible spaced apart from the first crucible in the first direction and accommodating a second deposition material.

In an embodiment, the plurality of deposition nozzles may include first deposition nozzles arranged in the second direction on the first crucible and second deposition nozzles arranged in the second direction on the second crucible.

According to an embodiment of the disclosure, a deposition apparatus includes a chamber, a substrate holder disposed inside the chamber, where the substrate holder supports a substrate, a mask assembly disposed below the substrate, and a deposition source which discharges a deposition material to the mask assembly, where the deposition source includes an individual deposition source, and a composite deposition source spaced apart from the individual deposition source in a first direction, where the individual deposition source discharges a single type of the deposition material and the composite deposition source discharges multiple different types of the deposition material.

In an embodiment, the individual deposition source may include an individual crucible accommodating the deposition material and having an open top, an individual cover plate covering the open top of the individual crucible, an individual deposition nozzle disposed on an upper surface of the individual cover plate, where the individual deposition nozzle discharges the deposition material, and an individual angle limiter disposed above the individual deposition nozzle, where an individual angle-limiting hole, through which the deposition material passes, is defined in the individual angle limiter, and the composite deposition source includes a first crucible accommodating a first deposition material and having an open top, a second crucible accommodating a second deposition material and having an open top, a first cover plate covering the open top of the first crucible, a second cover plate covering the open top of the second crucible, a first deposition nozzle disposed on an upper surface of the first cover plate, where the first deposition nozzle discharges the first deposition material, a second deposition nozzle disposed on an upper surface of the second cover plate and discharging the second deposition material, and a composite angle limiter disposed above the first and second deposition nozzles, where a composite angle-limiting hole, through which the first and second deposition materials pass, is defined in the composite angle limiter.

In an embodiment, an angle between an imaginary line extending from one side of the individual deposition nozzle in the first direction to one side of the individual angle-limiting hole in the first direction and an imaginary line parallel to the individual cover plate may be about 80° or greater.

In an embodiment, an angle between an imaginary line extending from one side of the first deposition nozzle in the first direction to one side of the composite angle-limiting hole in the first direction and an imaginary line parallel to the first cover plate may be greater than an angle between an imaginary line extending from the one side of the first deposition nozzle in the first direction to an opposite side of the composite angle-limiting hole in the first direction and the imaginary line parallel to the first cover plate.

In an embodiment, the angle between the imaginary line extending from the one side of the first deposition nozzle in the first direction to the one side of the composite angle-limiting hole in the first direction and the imaginary line parallel to the first cover plate may be 80° or greater.

In an embodiment, the angle between the imaginary line extending from the one side of the first deposition nozzle in the first direction to the opposite side of the composite angle-limiting hole in the first direction and the imaginary line parallel to the first cover plate may be about 80° or greater.

In an embodiment, an angle between an imaginary line extending from an opposite side of the second deposition nozzle in the first direction to an opposite side of the composite angle-limiting hole in the first direction and an imaginary line parallel to the second cover plate may be greater than an angle between an imaginary line extending from the opposite side of the second deposition nozzle in the first direction to one side of the composite angle-limiting hole in the first direction and the imaginary line parallel to the second cover plate.

In an embodiment, the angle between the imaginary line extending from the opposite side of the second deposition nozzle in the first direction to the opposite side of the composite angle-limiting hole in the first direction and the imaginary line parallel to the second cover plate may be about 80° or greater.

In an embodiment, the angle between the imaginary line extending from the opposite side of the second deposition nozzle in the first direction to the one side of the composite angle-limiting hole in the first direction and the imaginary line parallel to the second cover plate may be about 80° or greater.

At least some of the above and other features of the invention are set out in the claims.

In the deposition source and deposition apparatus according to embodiments of the invention, a high incidence angle of a deposition material onto a deposition substrate may be effectively maintained.

In the deposition source and deposition apparatus according to embodiments of the invention, by dividing and arranging a plurality of deposition nozzles into multiple groups in a way such that the deposition nozzles in each of the multiple groups are aggregated, the uniformity of the deposition material deposited on the deposition substrate may be ensured.

The effects according to the embodiments of the disclosure are not limited to those mentioned above and more various effects are included in the following description of the disclosure.

### BRIEF DESCRIPTION OF THE DRAWINGS

The above and other features of embodiments of the disclosure will become more apparent by describing in detail example embodiments thereof with reference to the attached drawings, in which:
FIG. 1 is a schematic diagram of a deposition apparatus according to an embodiment of the disclosure;
FIG. 2 is a schematic cross-sectional view of a deposition substrate for depositing a deposition material using the deposition apparatus according to an embodiment of the disclosure;
FIG. 3 is a cross-sectional view of the deposition substrate of FIG. 2 with a deposition material deposited thereon;
FIG. 4 is a schematic plan view illustrating a mask assembly 300 of FIG. 1;
FIG. 5 is a schematic plan view illustrating cell areas and grid areas of FIG. 4;
FIG. 6 is a schematic cross-sectional view taken along line I-I' of FIG. 5;
FIG. 7 is a plan view illustrating an embodiment where a deposition source of FIG. 1 is provided as an individual deposition source;
FIG. 8 is a cross-sectional view taken along line A-A' of FIG. 7;
FIG. 9 is a plan view illustrating an embodiment where the deposition source of FIG. 1 is provided as a composite deposition source;
FIG. 10 is a cross-sectional view taken along line B-B' of FIG. 9;
FIG. 11 is a plan view illustrating an embodiment where the deposition source 600 is provided as including both the individual deposition source and the composite deposition source; and
FIG. 12 is a cross-sectional view taken along line C-C' of FIG. 11.

### DETAILED DESCRIPTION

The invention now will be described more fully hereinafter with reference to the accompanying drawings, in which various embodiments are shown. This invention may, however, be embodied in many different forms, and should not be construed as limited to the embodiments set forth herein. Rather, these embodiments are provided so that this disclosure will be thorough and complete, and will fully convey the scope of the invention to those skilled in the art. Like reference numerals refer to like elements throughout.

It will be understood that when an element is referred to as being "on" another element, it can be directly on the other element or intervening elements may be present therebetween. In contrast, when an element is referred to as being "directly on" another element, there are no intervening elements present.

It will be understood that, although the terms "first," "second," "third" etc. may be used herein to describe various elements, components, regions, layers and/or sections, these elements, components, regions, layers and/or sections should not be limited by these terms. These terms are only used to distinguish one element, component, region, layer or section from another element, component, region, layer or section. Thus, "a first element," "component," "region," "layer" or "section" discussed below could be termed a second element, component, region, layer or section without departing from the teachings herein.

The terminology used herein is for the purpose of describing particular embodiments only and is not intended to be limiting. As used herein, "a", "an," "the," and "at least one" do not denote a limitation of quantity, and are intended to include both the singular and plural, unless the context clearly indicates otherwise. Thus, reference to "an" element in a claim followed by reference to "the" element is inclusive of one element and a plurality of the elements. For example, "an element" has the same meaning as "at least one element," unless the context clearly indicates otherwise. "At least one" is not to be construed as limiting "a" or "an." "Or" means "and/or." As used herein, the term "and/or" includes any and all combinations of one or more of the associated listed items. It will be further understood that the terms "comprises" and/or "comprising," or "includes" and/or "including" when used in this specification, specify the presence of stated features, regions, integers, steps, operations, elements, and/or components, but do not preclude the presence or addition of one or more other features, regions, integers, steps, operations, elements, components, and/or groups thereof.

Furthermore, relative terms, such as "lower" or "bottom" and "upper" or "top," may be used herein to describe one element's relationship to another element as illustrated in the Figures. It will be understood that relative terms are intended to encompass different orientations of the device in addition to the orientation depicted in the Figures. For example, if the device in one of the figures is turned over, elements described as being on the "lower" side of other elements would then be oriented on "upper" sides of the other elements. The term "lower," can therefore, encompass both an orientation of "lower" and "upper," depending on the particular orientation of the figure. Similarly, if the device in one of the figures is turned over, elements described as "below" or "beneath" other elements would then be oriented "above" the other elements. The terms "below" or "beneath" can, therefore, encompass both an orientation of above and below.

"About" or "approximately" as used herein is inclusive of the stated value and means within an acceptable range of deviation for the particular value as determined by one of ordinary skill in the art, considering the measurement in question and the error associated with measurement of the particular quantity (i.e., the limitations of the measurement system). For example, "about" can mean within one or more standard deviations, or within ± 30%, 20%, 10% or 5% of the stated value.

Unless otherwise defined, all terms (including technical and scientific terms) used herein have the same meaning as commonly understood by one of ordinary skill in the art to which this disclosure belongs. It will be further understood that terms, such as those defined in commonly used dictionaries, should be interpreted as having a meaning that is consistent with their meaning in the context of the relevant art and the present disclosure, and will not be interpreted in an idealized or overly formal sense unless expressly so defined herein.

Embodiments are described herein with reference to cross section illustrations that are schematic illustrations of embodiments. As such, variations from the shapes of the illustrations as a result, for example, of manufacturing techniques and/or tolerances, are to be expected. Thus, embodiments described herein should not be construed as limited to the particular shapes of regions as illustrated herein but are to include deviations in shapes that result, for example, from manufacturing. For example, a region illustrated or described as flat may, typically, have rough and/or nonlinear features. Moreover, sharp angles that are illustrated may be rounded. Thus, the regions illustrated in the figures are schematic in nature and their shapes are not intended to illustrate the precise shape of a region and are not intended to limit the scope of the present claims.

Hereinafter, embodiments of the disclosure will be described in detail with reference to the accompanying drawings.

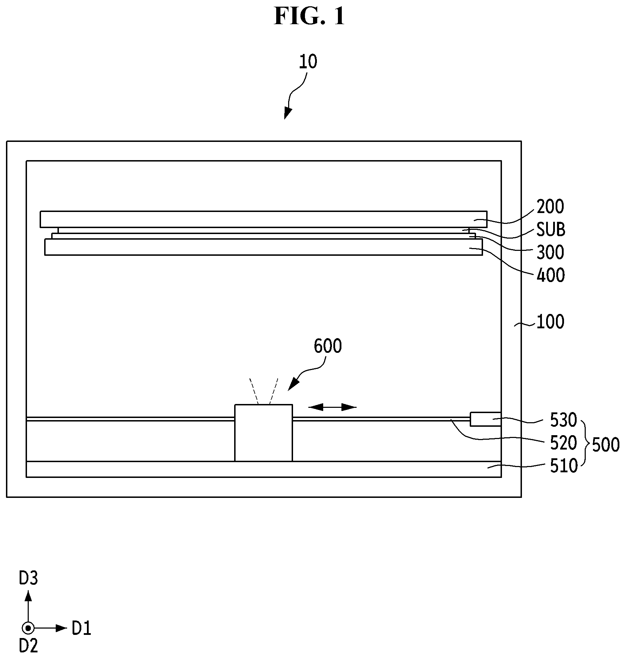

FIG. 1 schematically illustrates a deposition apparatus 10 according to an embodiment of the invention.

Referring to FIG. 1, the deposition apparatus 10 may deposit organic materials or metals used as electrodes onto a deposition substrate SUB for a display device. The display device, which is a device for displaying videos or still images, may be used as the display screen of various electronic devices such as mobile phones, smart phones, tablet personal computers (PCs), smart watches, watch phones, mobile communication terminals, electronic notebooks, e-book readers, portable multimedia players (PMPs), navigation devices, ultra-mobile PCs (UMPCs), as well as televisions (TVs), laptops, monitors, billboards, and Internet of Things (IoT) devices. These are merely presented as examples, and the display device may also be employed in other electronic devices. In an embodiment, the deposition apparatus 10 may include a chamber 100, a substrate holder 200, a mask assembly 300, a mask stage 400, a moving module 500, and a deposition source 600.

The chamber 100 may provide a space for performing a deposition process. The interior of the chamber 100 may be maintained in a vacuum state during the deposition process. Maintaining the interior of the chamber 100 in the vacuum state means keeping the pressure in the chamber 100 at a low level, which is substantially lower than an atmospheric pressure. The chamber 100 may include an entry/exit port (not illustrated) for loading and unloading the deposition substrate SUB. Additionally, the chamber 100 may include a vacuum pump (not illustrated) for controlling the pressure within the chamber 100 and an exhaust port (not illustrated) connected to the vacuum pump for exhausting deposition material not deposited on the deposition substrate SUB.

The substrate holder 200 may support the deposition substrate SUB. The substrate holder 200 may be disposed in (or inside) the chamber 100. In an embodiment, the substrate holder 200 may be disposed on the upper side of the interior of the chamber 100, and the deposition substrate SUB may be seated on and supported by the lower part of the substrate holder 200. Additionally, the substrate holder 200 may include a fixing member (not illustrated). The fixing member may assist in securing the deposition substrate SUB and the mask assembly 300, and may serve to uniformly maintain the distance between the deposition substrate SUB and the mask assembly 300. The fixing member may be provided as a detachable frame structure.

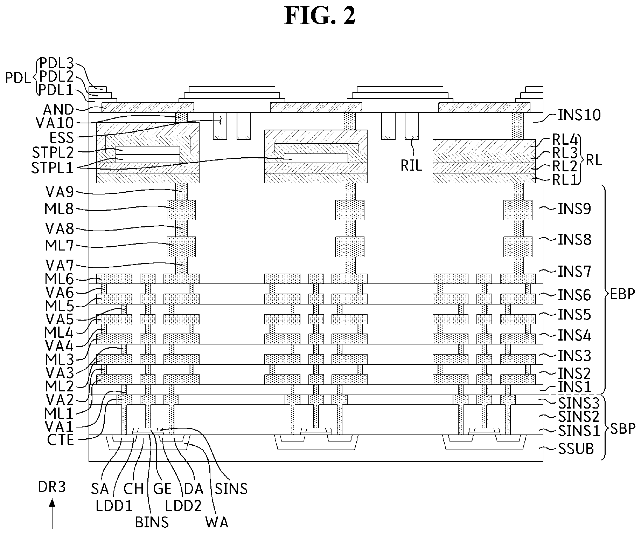

FIG. 2 is a schematic cross-sectional view of a deposition substrate SUB for depositing a deposition material using the deposition apparatus 10.

Referring to FIG. 2, in an embodiment, the deposition substrate SUB may include a semiconductor backplane SBP, an emission element backplane EBP, a reflective electrode layer RL, and a pixel-defining layer PDL.

The semiconductor backplane SBP includes a semiconductor substrate SSUB, which includes a plurality of pixel transistors, a plurality of semiconductor insulating layers, which cover the pixel transistors, and a plurality of contact terminals CTE, which are electrically connected to the pixel transistors.

The semiconductor substrate SSUB may be a silicon (Si) substrate, a germanium (Ge) substrate, or a silicon-germanium (SiGe) substrate. The semiconductor substrate SSUB may be a substrate doped with first-type impurities. A plurality of well areas WA may be disposed on the upper surface of the semiconductor substrate SSUB. The well areas WA may be doped with second-type impurities. The second-type impurities may be different from the first-type impurities. In an embodiment, for example, the first-type impurities are p-type impurities, and the second-type impurities may be n-type impurities. In another embodiment, for example, the first-type impurities are n-type impurities, and the second-type impurities may be p-type impurities.

Each of the well areas WA includes a source area SA, which corresponds to the source electrode of a pixel transistor, a drain area DA, which corresponds to the drain electrode of the pixel transistor, and a channel area CH, which is disposed between the source area SA and the drain area DA.

A lower insulating film BINS may be disposed between gate electrodes GE and the well areas WA. Side insulating films SINS may be disposed on the sides of the gate electrodes GE. The side insulating films SINS may be disposed on the lower insulating film BINS.

The source areas SA and the drain areas DA may each be regions doped with the first-type impurities. The gate electrodes GE of the pixel transistors may overlap the well areas WA in a third direction DR3 or a thickness direction of the semiconductor substrate SSUB. The channel areas CH may overlap the gate electrodes GE in the third direction DR3. The source areas SA may be disposed on the sides of the gate electrodes GE, and the drain areas DA may be disposed on the opposite sides of the gate electrodes GE.

Each of the well areas WA further includes a first low-density impurity region LDD1, which is disposed between the corresponding channel and source areas CH and SA, and a second low-density impurity region LDD2, which is disposed between the corresponding channel and drain areas CH and DA. The first low-density impurity regions LDD1 may have a lower impurity concentration than the source areas SA due to the lower insulating film BINS. The second low-density impurity regions LDD2 may have a lower impurity concentration than the drain areas DA due to the lower insulating film BINS. The distances between the source areas SA and the drain areas DA may be increased by the first low-density impurity regions LDD1 and the second low-density impurity regions LDD2. Therefore, the length of the channel areas CH of the pixel transistors can be increased, thereby effectively preventing punch-through and hot carrier phenomena caused by short channels from occurring.

A first semiconductor insulating film SINS1 may be disposed on the semiconductor substrate SSUB. The first semiconductor insulating film SINS1 may be formed as (or defined by) a silicon carbon nitride (SiCN)-based or silicon oxide (SiOₓ)-based inorganic film, but the disclosure is not limited thereto.

A second semiconductor insulating film SINS2 may be disposed on the first semiconductor insulating film SINS1. The second semiconductor insulating film SINS2 may be formed as a SiOₓ-based inorganic film, but the disclosure is not limited thereto.

A plurality of contact terminals CTE may be disposed on the second semiconductor insulating film SINS2. The contact terminals CTE may be connected to the gate electrodes GE, the source areas SA, or the drain areas DA of the respective pixel transistors through holes penetrating (defined or formed through) the first and second semiconductor insulating films SINS 1 and SINS2. The contact terminals CTE may include or be formed of copper (Cu), aluminium (Al), tungsten (W), molybdenum (Mo), chromium (Cr), gold (Au), titanium (Ti), nickel (Ni), neodymium (Nd), or an alloy thereof.

A third semiconductor insulating film SINS3 may be disposed on the sides of the contact terminals CTE. The upper surfaces of the contact terminals CTE may not be covered by the third semiconductor insulating film SINS3 and may remain exposed. The third semiconductor insulating film SINS3 may be formed as a SiOₓ-based inorganic film, but the disclosure is not limited thereto.

In an embodiment, the semiconductor substrate SSUB may be replaced with a glass substrate or a polymer resin substrate such as a polyimide substrate. In such an embodiment, thin-film transistors (TFTs) may be disposed on the glass substrate or polymer resin substrate. The glass substrate may be a rigid substrate that does not bend, and the polymer resin substrate may be a flexible substrate that can bend or curve.

The emission element backplane EBP includes a plurality of conductive layers (MI,1 through ML8) and a plurality of vias (VA1 through VA9). Additionally, the emission element backplane EBP includes a plurality of first through ninth insulating films INS1 through INS9, which are disposed between the conductive layers (ML1 through ML8).

The conductive layers (MI,1 through ML8) serve to connect the contact terminals CTE exposed from the semiconductor backplane SBP, to implement the circuitry of sub-pixels.

The first insulating film INS1 may be disposed on the semiconductor backplane SBP. First vias VA1 may penetrate (or extend through) the first insulating film INS1 to be connected to the contact terminals CTE exposed from the semiconductor backplane SBP through the first insulating film INS1. First conductive layers ML1 may be disposed on the first insulating film INS1 and may be connected to the first vias VA1.

The second insulating film INS2 may be disposed on the first insulating film INS1 and the first conductive layers ML1. Second vias VA2 may penetrate the second insulating film INS2 to be connected to the first conductive layers ML1 exposed through the second insulating film INS2. Second conductive layers ML2 may be disposed on the second insulating film INS2 and may be connected to the second vias VA2.

The third insulating film INS3 may be disposed on the second insulating film INS2 and the second conductive layers ML2. Third vias VA3 may penetrate the third insulating film INS3 to be connected to the second conductive layers ML2 exposed through the third insulating film INS3. Third conductive layers ML3 may be disposed on the third insulating film INS3 and may be connected to the third vias VA3.

The fourth insulating film INS4 may be disposed on the third insulating film INS3 and the third conductive layers ML3. Fourth vias VA4 may penetrate the fourth insulating film INS4 to be connected to the third conductive layers ML3 exposed through the fourth insulating film INS4. Fourth conductive layers ML4 may be disposed on the fourth insulating film INS4 and may be connected to the fourth vias VA4.

The fifth insulating film INS5 may be disposed on the fourth insulating film INS4 and the fourth conductive layers ML4. Fifth vias VA5 may penetrate the fifth insulating film INS5 to be connected to the fourth conductive layers ML4 exposed through the fifth insulating film INS5. Fifth conductive layers ML5 may be disposed on the fifth insulating film INS5 and may be connected to the fifth vias VA5.

The sixth insulating film INS6 may be disposed on the fifth insulating film INS5 and the fifth conductive layers ML5. Sixth vias VA6 may penetrate the sixth insulating film INS6 to be connected to the fifth conductive layers ML5 exposed through the sixth insulating film INS6. Sixth conductive layers ML6 may be disposed on the sixth insulating film INS6 and may be connected to the sixth vias VA6.

The seventh insulating film INS7 may be disposed on the sixth insulating film INS6 and the sixth conductive layers ML6. Seventh vias VA7 may penetrate the seventh insulating film INS7 to be connected to the sixth conductive layers ML6 exposed through the seventh insulating film INS7. Seventh conductive layers ML7 may be disposed on the seventh insulating film INS7 and may be connected to the seventh vias VA7.

The eighth insulating film INS8 may be disposed on the seventh insulating film INS7 and the seventh conductive layers ML7. Eighth vias VA8 may penetrate the eighth insulating film INS8 to be connected to the seventh conductive layers ML7 exposed through the eighth insulating film INS8. Eighth conductive layers ML8 may be disposed on the eighth insulating film INS8 and may be connected to the eighth vias VA8.

The conductive layers (MI,1 through ML8) and the vias (VA1 through VA8) may include or be formed of substantially a same material as each other. The conductive layers (ML1 through ML8) and the vias (VA1 through VA8) may include or be formed of Cu, Al, W, Mo, Cr, Au, Ti, Ni, Nd, or an alloy thereof. The first through eighth insulating films INS1 through INS8 may include or be formed of substantially a same material as each other. The first through eighth insulating films INS1 through INS8 may include or be formed as SiOₓ-based inorganic films, but the disclosure is not limited thereto.

The thicknesses of the first conductive layers ML1, the second conductive layers ML2, the third conductive layers ML3, the fourth conductive layers ML4, the fifth conductive layers ML5, and the sixth conductive layers ML6 may be greater than the thicknesses of the first vias VA1, the second vias VA2, the third vias VA3, the fourth vias VA4, the fifth vias VA5, and the sixth vias VA6. The thicknesses of the second, third, fourth, fifth, and sixth conductive layers ML2, ML3, ML4, ML5, and ML6 may be greater than the thickness of the first conductive layers ML1. The thicknesses of the second conductive layers ML2, the third conductive layers ML3, the fourth conductive layers ML4, the fifth conductive layers ML5, and the sixth conductive layers ML6 may be substantially the same as each other. In an embodiment, for example, the thickness of the first conductive layers ML1 may be about 1,360 angstrom (Å), the thicknesses of the second conductive layers ML2, the third conductive layers ML3, the fourth conductive layers ML4, the fifth conductive layers ML5, and the sixth conductive layers ML6 may be about 1,440 Å, and the thicknesses of the first vias VA1, the second vias VA2, the third vias VA3, the fourth vias VA4, the fifth vias VA5, and the sixth vias VA6 may be about 1,150 Å.

The thicknesses of the seventh conductive layers ML7 and the eighth conductive layers ML8 may be greater than the thicknesses of the first conductive layers ML1, the second conductive layers ML2, the third conductive layers ML3, the fourth conductive layers ML4, the fifth conductive layers ML5, and the sixth conductive layers ML6. The thicknesses of the seventh conductive layers ML7 and the eighth conductive layers ML8 may be greater than the thicknesses of the seventh vias VA7 and the eighth vias VA8. The thicknesses of the seventh vias VA7 and the eighth vias VA8 may be greater than the thicknesses of the first vias VA1, the second vias VA2, the third vias VA3, the fourth vias VA4, the fifth vias VA5, and the sixth vias VA6. The thicknesses of the seventh conductive layers ML7 and the eighth conductive layers ML8 may be substantially the same as each other. In an embodiment, for example, the thicknesses of the seventh conductive layers ML7 and the eighth conductive layers ML8 may be about 9,000 Å. The thicknesses of the seventh vias VA7 and the eighth vias VA8 may be about 6,000 Å.

The ninth insulating film INS9 may be disposed on the eighth insulating film INS8 and the eighth conductive layers ML8. The ninth insulating film INS9 may be formed as a SiOₓ-based inorganic film, but the disclosure is not limited thereto.

Ninth vias VA9 may penetrate the ninth insulating film INS9 to be connected to the eighth conductive layer ML8 exposed through the ninth insulating film INS9. The ninth vias VA9 may include or be formed of Cu, Al, W, Mo, Cr, Au, Ti, Ni, Nd, or an alloy thereof. In an embodiment, for example, the thickness of the ninth vias VA9 may be about 16,500Å.

The reflective electrode layer RL may be disposed on the ninth insulating film INS9. The reflective electrode layer RL may include one or more reflective electrodes (RL1 through RL4), a first step layer STPL1, and a second step layer STPL2. In an embodiment, for example, the reflective electrode layer RL may include first reflective electrodes RL1, second reflective electrodes RL2, third reflective electrodes RL3, and fourth reflective electrodes RL4, but the disclosure is not limited thereto.

The first reflective electrodes RL1 may be disposed on the ninth insulating film INS9 and may be connected to the ninth vias VA9. The first reflective electrodes RL1 may include or be formed of Cu, Al, W, Mo, Cr, Au, Ti, Ni, Nd, or an alloy thereof. For example, the first reflective electrodes RL1 may include titanium nitride (TiN).

The second reflective electrodes RL2 may be disposed on the first reflective electrodes RL1. The second reflective electrodes RL2 may be formed of Cu, Al, W, Mo, Cr, Au, Ti, Ni, Nd, or an alloy thereof. In an embodiment, for example, the second reflective electrodes RL2 may include Al.

The first step layer STPL1 may be disposed on the second reflective electrode RL2. The second step layer STPL2 may be disposed on the first step layer STPL1.

The first and second step layers STPL1 and STPL2 may be formed as SiC- or SiOₓ-based inorganic films, but the disclosure is not limited thereto.

In an embodiment, the third reflective electrodes RL3 may be disposed on the second reflective electrodes RL2. In embodiment, where the first step layer STPL1 is disposed on the second reflective electrodes RL2, the third reflective electrodes RL3 may be disposed on the first step layer STPL1. In embodiment, where the first and second step layers STPL1 and STPL2 are sequentially disposed on the second reflective electrodes RL2, the third reflective electrodes RL3 may be disposed on the second step layer STPL2. The third reflective electrodes RL3 may include or be formed of Cu, Al, W, Mo, Cr, Au, Ti, Ni, Nd, or an alloy thereof. In an embodiment, for example, the third reflective electrodes RL3 may include TiN.

In another embodiment, the first reflective electrode RL1, the second reflective electrode RL2, and/or the third reflective electrode RL3 may be omitted.

The fourth reflective electrodes RL4 may be disposed on the third reflective electrodes RL3. The fourth reflective electrodes RL4 may include a metal with a high reflectivity to facilitate light reflection. Additionally, the thickness of the fourth reflective electrodes RL4 may be greater than the thicknesses of the first reflective electrodes RL1, the second reflective electrodes RL2, and the third reflective electrodes RL3. The fourth reflective electrodes RL4 may include or be formed of Cu, Al, W, Mo, Cr, Au, Ti, Ni, Nd, or an alloy thereof. In another embodiment, for example, the fourth reflective electrodes RL4 may include Al or Ti.

A tenth interlayer insulating film INS10 may be disposed on the ninth interlayer insulating film INS9 and the fourth reflective electrodes RL4. The tenth interlayer insulating film INS 10 may be formed as a SiOₓ-based inorganic film, but the disclosure is not limited thereto.

Tenth vias VA10 may penetrate the tenth interlayer insulating film INS10 to be connected to the reflective electrode layer RL exposed through the tenth interlayer insulating film INS10. The tenth vias VA10 may include or be formed of Cu, Al, W, Mo, Cr, Au, Ti, Ni, Nd, or an alloy thereof.

First electrodes AND of light-emitting elements may be disposed on the tenth insulating film INS10 and may be connected to the tenth vias VA10. The first electrodes AND of the light-emitting elements may be connected to the drain or source areas DA or SA of the pixel transistors through the tenth vias VA10, the first reflective electrodes RL1, the second reflective electrodes RL2, the third reflective electrodes RL3, the fourth reflective electrodes RL4, the first vias VA1, the second vias VA2, the third vias VA3, the fourth vias VA4, the fifth vias VA5, the sixth vias VA6, the seventh vias VA7, the eighth vias VA8, the ninth vias VA9, the first conductive layers ML1, the second conductive layers ML2, the third conductive layers ML3, the fourth conductive layers ML4, the fifth conductive layers ML5, the sixth conductive layers ML6, the seventh conductive layers ML7, the eighth conductive layers ML8, and the contact terminals CTE. The first electrodes AND of the light-emitting elements may include or be formed of Cu, Al, W, Mo, Cr, Au, Ti, Ni, Nd, or an alloy thereof. In an embodiment, for example, the first electrodes AND of the light-emitting elements may include TiN.

The pixel-defining layer PDL may be disposed on parts of the first electrodes AND of the light-emitting elements. The pixel-defining layer PDL may cover the edges of each of the first electrodes AND of the light-emitting elements.

The pixel-defining layer PDL may include first, second, and third pixel defining layers PDL1, PDL2, and PDL3. The first pixel-defining layer PDL1 may be disposed on the edges of each of the first electrodes AND of the light-emitting elements, the second pixel-defining layer PDL2 may be disposed on the first pixel-defining layer PDL1, and the third pixel-defining layer PDL3 may be disposed on the second pixel-defining layer PDL2. The first, second, and third pixel-defining layers PDL1, PDL2, and PDL3 may be formed as SiOₓ-based inorganic films, but the disclosure is not limited thereto. In an embodiment, for example, the thicknesses of the first, second, and third pixel-defining layers PDL1, PDL2, and PDL3 may be about 500Å.

The first, second, and third pixel-defining layers PDL1, PDL2, and PDL3 may have a cross-sectional structure with a step-like profile. In an embodiment, for example, the width of the first pixel-defining layer PDL1 may be greater than the widths of the second pixel-defining layer PDL2 and the third pixel-defining layer PDL3, and the width of the second pixel-defining layer PDL2 may be greater than the width of the third pixel-defining layer PDL3.

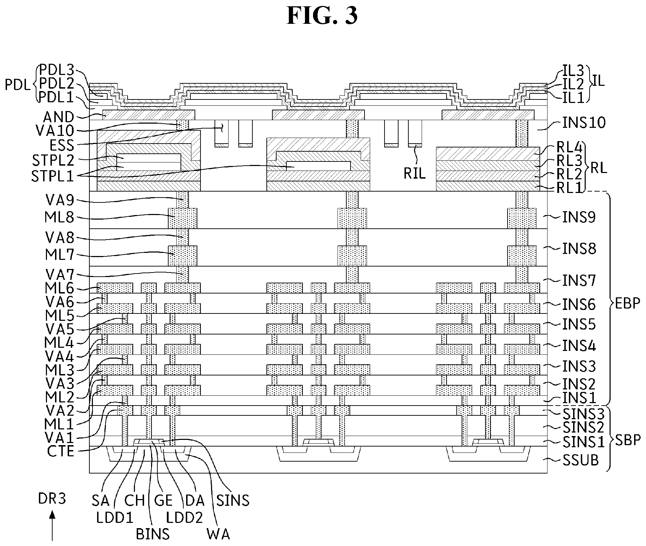

FIG. 3 is a cross-sectional view of the deposition substrate SUB of FIG. 2 with a deposition material deposited thereon.

Referring to FIG. 3, in an embodiment, a deposition material may be deposited on the upper surface of the deposition substrate SUB. In such an embodiment, the deposition material may be deposited on the pixel-defining layer PDL and the first electrodes AND. The deposition material deposited on the upper surface of the deposition substrate SUB may form an emission stack IL.

The emission stack IL may include a plurality of intermediate layers. In an embodiment, as shown in FIG. 3, the emission stack IL may have a three-tandem structure that includes a first stack layer IL1, a second stack layer IL2, and a third stack layer IL3, but the disclosure is not limited thereto. Alternatively, the emission stack IL may have a two-tandem structure that includes two stack layers.

In an embodiment where the emission stack IL has the three-tandem structure, the emission stack IL may include three stack layers that emit different colors of light, i.e., first, second, and third stack layers IL1, IL2, and IL3. In an embodiment, for example, the emission stack IL may include a first stack layer IL1 that emits light of a first color, a second stack layer IL2 that emits light of a third color, and a third stack layer IL3 that emits light of a second color. The first stack layer IL1, the second stack layer IL2, and the third stack layer IL3 may be sequentially stacked one on another.

The first stack layer IL1 may have a structure in which a first hole transport layer, a first organic light-emitting layer emitting light of the first color, and a first electron transport layer are sequentially stacked one on another. The second stack layer IL2 may have a structure in which a second hole transport layer, a second organic light-emitting layer emitting light of the third color, and a second electron transport layer are sequentially stacked one on another. The third stack layer IL3 may have a structure in which a third hole transport layer, a third organic light-emitting layer emitting light of the second color, and a third electron transport layer are sequentially stacked one on another.

A first charge generation layer for supplying charge to the second stack layer IL2 and electrons to the first stack layer IL1 may be disposed between the first and second stack layers IL1 and IL2. The first charge generation layer may include an n-type charge generation layer supplying electrons to the first stack layer IL1 and a p-type charge generation layer supplying holes to the second stack layer IL2. The n-type charge generation layer may include a dopant of a metal material.

A second charge generation layer for supplying charge to the third stack layer IL3 and electrons to the second stack layer IL2 may be disposed between the second stack layer IL2 and the third stack layer IL3. The second charge generation layer may include an n-type charge generation layer supplying electrons to the second stack layer IL2 and a p-type charge generation layer supplying holes to the third stack layer IL3.

The first stack layer IL1 may be disposed on the first electrodes AND and the pixel-defining layer PDL, the second stack layer IL2 may be disposed on the first stack layer IL1, and the third stack layer IL3 may be disposed on the second stack layer IL2.

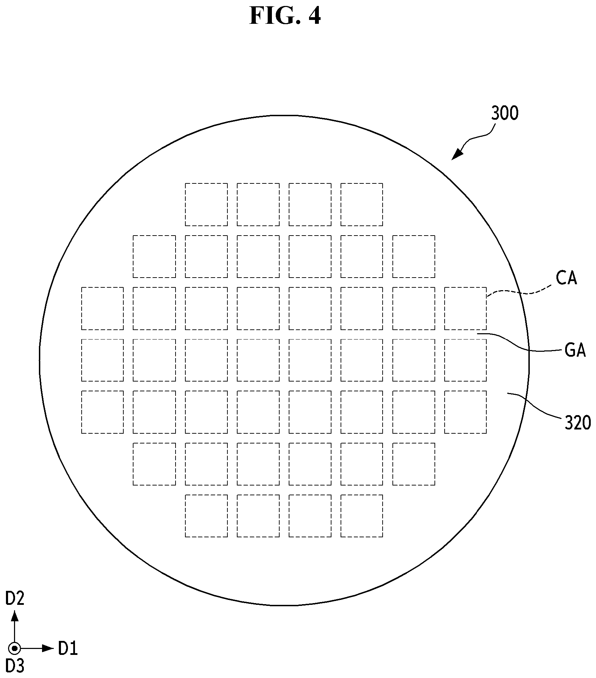

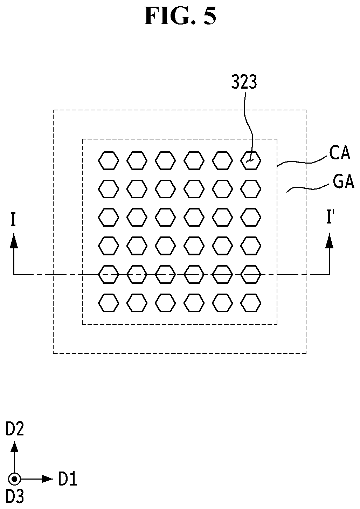

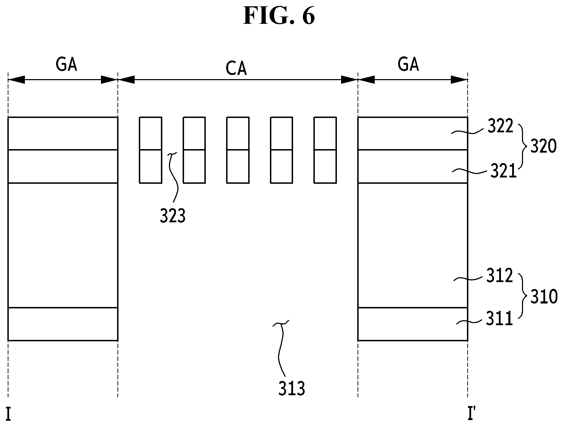

FIG. 4 is a schematic plan view illustrating the mask assembly 300 of FIG. 1. FIG. 5 is a schematic plan view illustrating cell areas CA and grid areas GA of FIG. 4. FIG. 6 is a schematic cross-sectional view taken along line I-I' of FIG. 5.

Referring to FIGS. 4 through 6, an embodiment of the mask assembly 300 may include a mask frame 310 and a membrane 320, which is disposed on the mask frame 310. In an embodiment, for example, the mask frame 310 may include an inorganic layer 311 and a base layer 312, which is disposed on the inorganic layer 311. Additionally, the membrane 320 may include an insulating layer 321, which is disposed on the base layer 312, and an inorganic layer 322, which is disposed on the insulating layer 321. In an embodiment, the mask assembly 300 may be a fine silicon mask (FSM).

The membrane 320 may include one or more cell areas CA. In an embodiment, for example, the membrane 320 may include a plurality of cell areas CA arranged in a matrix form along a first direction D1 and a second direction D2 crossing the first direction D1, and grid areas GA disposed between the cell areas CA. Here, a third direction D3 may be a direction perpendicular to the first direction D1 and the second direction D2.

The mask frame 310 may have a plurality of cell openings 313 exposing the cell areas CA of the membrane 320. The cell areas CA of the membrane 320 may be disposed on the respective cell openings 313 of the mask frame 310.

Each of the cell areas CA of the membrane 320 may be provided with a plurality of pixel openings 323. The pixel openings 323 may be defined or formed to penetrate their corresponding cell area CA. In such an embodiment, the pixel openings 323 of the membrane 320 may be connected to the cell openings 313 of the mask frame 310, and the cell openings 313 of the mask frame 310 and the pixel openings 323 of the membrane 320 may function as paths for providing a light-emitting material to the anode electrodes of the substrate SUB during a deposition process for forming light-emitting layers.

Referring back to FIG. 1, the mask stage 400 may be disposed below the mask assembly 300 to support the mask assembly 300. A stage opening may be formed at the center of the mask stage 400. The stage opening formed at the center of the mask stage 400 may overlap with the cell openings 313 of the mask assembly 300 and with the pixel openings 323.

The moving module 500 may move the deposition source 600 in the first direction D1. The moving module 500 may include guide rails 510, a moving shaft 520, and a moving motor 530.

The guide rails 510 may be disposed along the first direction D1 on the inner lower surface of the chamber 100. In an embodiment where a pair of guide rails 510 are provided, the guide rails 510 may be arranged to support both opposing edges of the deposition source 600 in the first direction D1.

The moving shaft 520 may be provided as a ball screw and may be screw-coupled to one side of the deposition source 600. Thus, as the moving shaft 520 rotates, the deposition source 600 may move in the first direction D1.

The moving motor 530 may be connected to the moving shaft 520 to rotate the moving shaft 520. The moving motor 530 may be supported by the inner surface of the chamber 100 and may be connected to the moving shaft 520.

The deposition source 600 may discharge a deposition material to the mask assembly 300. The deposition source 600 may be provided as an individual (or single) deposition source 610 that discharges a single type of deposition material.

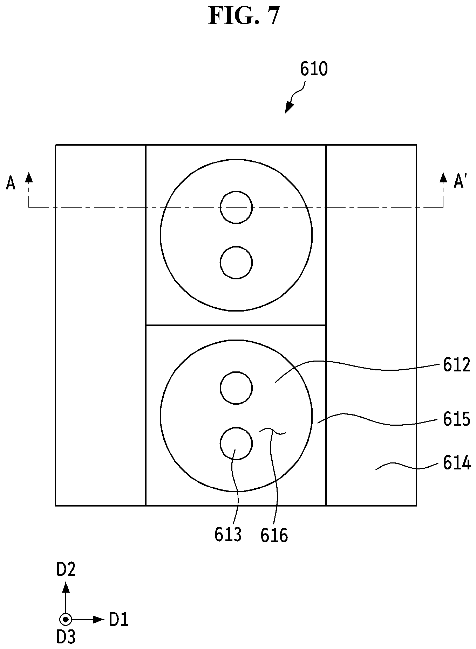

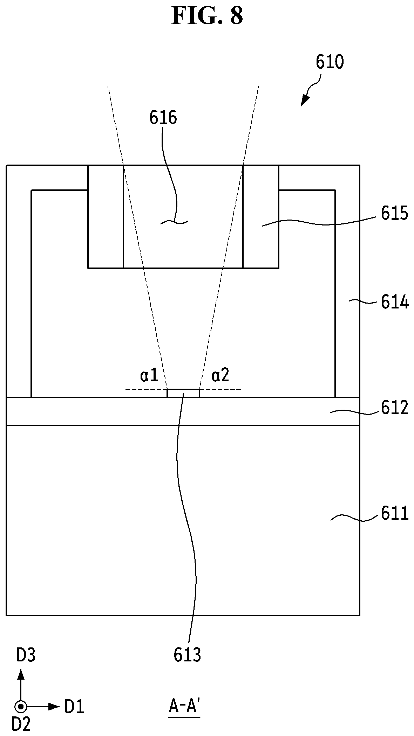

FIG. 7 is a plan view illustrating an embodiment where the deposition source 600 of FIG. 1 is provided as an individual deposition source 610. FIG. 8 is a cross-sectional view taken along line A-A' of FIG. 7.

Referring to FIGS. 7 and 8, in an embodiment, the individual deposition source 610 may include an individual crucible (or container) 611, an individual cover plate 612, individual deposition nozzles 613, individual support plates 614, individual angle limiters 615, and individual angle-limiting holes 616.

The individual crucible 611 may accommodate a deposition material. In other words, the individual crucible 611 may include an accommodation space for containing the deposition material, and the deposition material may be contained in the accommodation space. A plurality of partition walls (not illustrated) may be arranged within the individual crucible 611 to prevent the deposition material from being stored biased toward one direction. Additionally, a separate heater (not illustrated) for vaporizing the deposition material may be disposed inside the individual crucible 611. The individual crucible 611 may have a shape with an open top.

The individual crucible 611 may include or be formed of a material characterized by a low coefficient of thermal expansion at high temperatures. In an embodiment, for example, the individual crucible 611 may include or be formed of a material such as Cr, Mo, platinum (Pt), W, or Ti, but the material of the individual crucible 611 is not particularly limited as long as it has a low coefficient of thermal expansion at high temperatures.

The deposition material contained in the individual crucible 611 may be an organic material for forming an organic light-emitting layer. The deposition material may be an organic material for forming a hole injection layer, a hole transport layer, an electron transport layer, or an electron injection layer, but the disclosure is not limited thereto. That is, various materials may be applied as the deposition material.

The individual cover plate 612 may cover the open top of the individual crucible 611. The individual cover plate 612 may be provided as a plate (or be in a plate shape) with a predetermined thickness in the third direction D3. The individual cover plate 612 may be formed to match the size of the open top of the individual crucible 611, to close the open top of the individual crucible 611.

The individual deposition nozzles 613 may be disposed at the top of the individual cover plate 612 and may discharge the deposition material contained in the individual crucible 611 in the third direction D3. The individual deposition nozzles 613 may be formed to communicate with the internal accommodation space of the individual crucible 611, thereby allowing the vaporized deposition material inside the individual crucible 611 to be discharged in the third direction D3 through the individual deposition nozzles 613.

A plurality of individual deposition nozzles 613 may be provided. In an embodiment, as shown in FIG. 7, the individual deposition nozzles 613 may be arranged to be spaced apart from one another in the second direction D2. The individual deposition nozzles 613 may be divided into multiple groups, and the distance between the individual deposition nozzles 613 in each of the groups may be smaller than the distance between the groups. In other words, the individual deposition nozzles 613 may be spaced apart from one another by a predetermined distance to form the groups, and the groups may be arranged to be spaced apart from one another by a greater distance than the predetermined distance between the individual deposition nozzles 613 in each of the groups.

The individual support plates 614 may extend in the third direction D3 from the individual cover plate 612. A plurality of individual support plates 614 may be provided and may be disposed on both opposing sides, in the first direction D1, of the individual cover plate 612 (i.e., left and right sides in FIG. 8).

The individual support plates 614 may be provided as plates with a predetermined thickness in the first direction D1. In an embodiment, as shown in FIG. 7, the individual support plates 614 may extend along the second direction D2 from the opposing sides, in the first direction D1, of the individual cover plate 612 in a plan view or when viewed in the third direction D3.

The upper ends of the individual support plates 614 may bend toward the center of the individual cover plate 612. In an embodiment, the upper end of the individual support plate 614 disposed on a first side (or the left side in FIG. 8), in the first direction D1, of the individual cover plate 612 may bend toward a second side (or the right side in FIG. 8), in the first direction D1, of the individual cover plate 612, and the upper end of the individual support plate 614 disposed on the second side (or the right side in FIG. 8) of the individual cover plate 612 may bend toward the first side (or the left side in FIG. 8) of the individual cover plate 612.

The individual angle limiters 615 may restrict the emission angle of the deposition material discharged from the individual deposition nozzles 613. The individual angle limiters 615 may be supported by the individual support plates 614 to be positioned above the individual deposition nozzles 613. In an embodiment, the individual angle limiters 615 may be formed in a rectangular box shape and may be disposed between the individual support plate 614 on the first side (or the left side in FIG. 8) of the individual cover plate 612 and the individual support plate 614 on the second side (or the right side in FIG. 8) of the individual cover plate 612.

The individual angle-limiting holes 616 may be provided as (or defined by) holes formed at the centers of the individual angle limiters 615. The individual angle-limiting holes 616 may allow some of the deposition material discharged from the individual deposition nozzles 613 to pass therethrough while restricting some of the deposition material to limit the emission angle of the deposition material. In an embodiment, the individual angle-limiting holes 616 may be circular in a plan view or when viewed from above the individual angle limiters 615 in the third direction D3, but the disclosure is not limited thereto. Alternatively, the individual angle-limiting holes 616 may be provided as square or polygonal holes.

A plurality of individual angle limiters 615 may be provided and may be arranged in the second direction D2 in a way such that the individual angle-limiting holes 616 may be located above (or to overlap) the groups of the individual deposition nozzles 613.

When an imaginary line extending from a first side (or the left side in FIG. 8), in the first direction D1, of the individual deposition nozzles 613 to the top of the individual angle-limiting holes 616 is referred to as a first line, and an imaginary line extending from the first side of the individual deposition nozzles 613 to a point where an imaginary line extending from a first side, in the first direction D1, of the individual angle-limiting holes 616 to the individual cover plate 612 and an imaginary line extending from the first side of the individual deposition nozzles 613 parallel to the individual cover plate 612 meet each other is referred to as a second line, the first line may be longer than the second line. The first line may be perpendicular to the individual cover plate 612, and the second line may be parallel to the individual cover plate 612. Furthermore, the first line may be at least five times longer than the second line.

When an imaginary line extending from the first side of the individual deposition nozzles 613 to the first side of the individual angle-limiting holes 616 is referred to as the third line, an angle α1 between the third line and the second line may be about 80° or greater.

When an imaginary line extending from a second side (or the right side in FIG. 8), in the first direction D1, of the individual deposition nozzles 613 to the top of the individual angle-limiting holes 616 is referred to as a fourth line, and an imaginary line extending from the second side of the individual deposition nozzles 613 to a point where an imaginary line extending from a second side, in the first direction D1, of the individual angle-limiting holes 616 to the individual cover plate 612 and an imaginary line extending from the second side of the individual deposition nozzles 613 parallel to the individual cover plate 612 meet each other is referred to as a fifth line, the fourth line may be longer than the fifth line. The fourth line may be perpendicular to the individual cover plate 612, and the fifth line may be parallel to the individual cover plate 612. Furthermore, the fourth line may be at least five times longer than fifth line.

When an imaginary line extending from the second side (or the right side in FIG. 8) of the individual deposition nozzles 613 to the second side of the individual angle-limiting holes 616 is referred to as a sixth line, an angle α2 between the sixth line and the fifth line may be about 80° or greater.

Additionally, the deposition source 600 may be provided as a composite deposition source 620 that discharges different types of deposition materials.

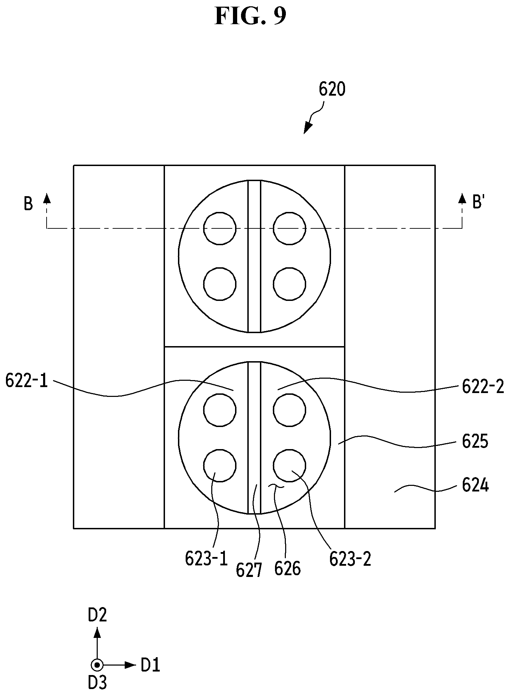

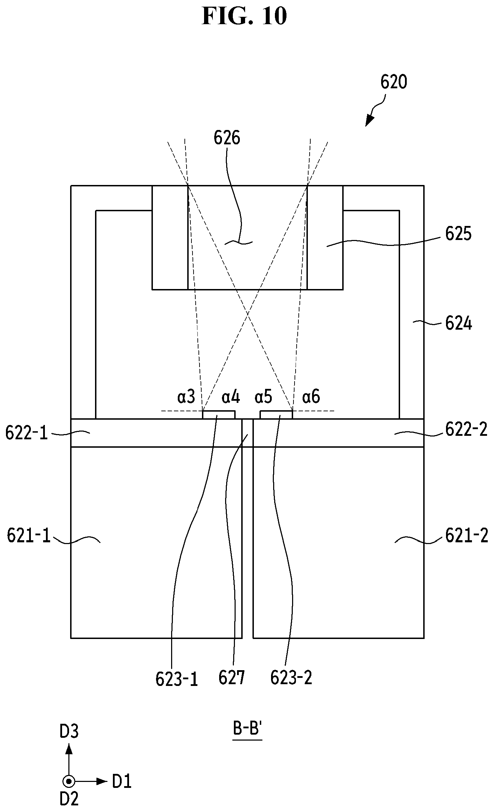

FIG. 9 is a plan view illustrating an embodiment where the deposition source 600 of FIG. 1 is provided as a composite deposition source 620. FIG. 10 is a cross-sectional view taken along line B-B' of FIG. 9.

Referring to FIGS. 9 and 10, the composite deposition source 620 may include a first crucible 621-1, a second crucible 621-2, a first cover plate 622-1, a second cover plate 622-2, first deposition nozzles 623-1, second deposition nozzles 623-2, composite support plates 624, composite angle limiters 625, composite angle-limiting holes 626, and a connecting plate 627.

The first crucible 621-1 may accommodate a first deposition material. In other words, the first crucible 621-1 may include an accommodation space for containing the first deposition material, and the first deposition material may be contained in the accommodation space. A plurality of partition walls (not illustrated) may be arranged within the first crucible 621-1 to effectively prevent the first deposition material from being stored biased toward one direction. Additionally, a separate heater (not illustrated) for vaporizing the first deposition material may be disposed inside the first crucible 621-1. The first crucible 621-1 may have a shape with an open top.

The second crucible 621-2 may be spaced apart from the first crucible 621-1 in the first direction D1. The second crucible 621-2 may accommodate a second deposition material. In other words, the second crucible 621-2 may include an accommodation space for containing the second deposition material, and the second deposition material may be housed in this accommodation space. The second deposition material may be of a different type from the first deposition material. A plurality of partition walls (not illustrated) may be arranged within the second crucible 621-2 to effectively prevent the second deposition material from being stored biased toward one direction. Additionally, a separate heater (not illustrated) for vaporizing the second deposition material may be disposed inside the second crucible 621-2. The second crucible 621-2 may have a shape with an open top.

The first and second crucibles 621-1 and 621-2 may include or be formed of a material characterized by a low coefficient of thermal expansion at high temperatures. In an embodiment, the first and second crucibles 621-1 and 621-2 may include or be formed of a material such as Cr, Mo, Pt, W, or Ti, but the material of the crucibles is not particularly limited as long as it has a low coefficient of thermal expansion at high temperatures.

The first and second deposition materials contained in the first and second crucibles 621-1 and 621-2, respectively, may be organic materials for forming an organic light-emitting layer. The first and second deposition materials may be organic materials for forming a hole injection layer, a hole transport layer, an electron transport layer, or an electron injection layer, but the disclosure is not limited thereto. That is, various materials may be applied as the first and second deposition materials.

The first cover plate 622-1 may cover the open top of the first crucible 621-1. The first cover plate 622-1 may be provided as a plate with a predetermined thickness in the third direction D3. The first cover plate 622-1 may be formed to match the size of the open top of the first crucible 621-1, to close the open top of the first crucible 621-1.

The second cover plate 622-2 may cover the open top of the second crucible 621-2. The second cover plate 622-2 may be provided as a plate with a predetermined thickness in the third direction D3. The second cover plate 622-2 may be formed to match the size of the open top of the second crucible 621-2, to close the open top of the second crucible 621-2.

The first deposition nozzles 623-1 may be disposed on the upper surface of the first cover plate 622-1 and may discharge the first deposition material contained in the first crucible 621-1 in the third direction D3. The first deposition nozzles 623-1 may be formed to communicate with the internal accommodation space of the first crucible 621-1, thereby allowing the vaporized first deposition material inside the first crucible 621-1 to be discharged through the first deposition nozzles 623-1 in the third direction D3.

A plurality of first deposition nozzles 623-1 may be provided. The first deposition nozzles 623-1 may be arranged to be spaced apart from one another in the second direction D2.

The second deposition nozzles 623-2 may be disposed on the upper surface of the second cover plate 622-2 and may discharge the second deposition material contained in the second crucible 621-2 in the third direction D3. The second deposition nozzles 623-2 may be formed to communicate with the internal accommodation space of the second crucible 621-2, thereby allowing the vaporized second deposition material inside the second crucible 621-2 to be discharged through the second deposition nozzles 623-2 in the third direction D3.

A plurality of second deposition nozzles 623-2 may be provided. The second deposition nozzles 623-2 may be arranged to be spaced apart from one another in the second direction D2.

The first deposition nozzles 623-1 and the second deposition nozzles 623-2 may be divided into multiple groups. The distance between the first deposition nozzles 623-1 and the second deposition nozzles 623-2 in each of the groups may be smaller than the distance between the groups. In other words, the first deposition nozzles 623-1 and the second deposition nozzles 623-2 may be spaced apart from one another by a predetermined distance to form the groups, and the groups may be arranged to be spaced apart from one another by a greater distance than the predetermined distance between the first deposition nozzles 623-1 and the second deposition nozzles 623-2 in each of the groups. Each of the groups may be composed of a combination of the first deposition nozzles 623-1 and the second deposition nozzles 623-2.

The composite support plates 624 may extend in the third direction D3 from the first and second cover plates 622-1 and 622-2. A plurality of composite support plates 624 may be provided and may be disposed on both sides, in the first direction D1, of the first and second cover plates 622-1 and 622-2 (i.e., left and right sides in FIG. 10).

The composite support plates 624 may be provided as plates with a predetermined thickness in the first direction D1. The composite support plates 624 may extend along the second direction D2 from both sides, in the first direction D1, of the first and second cover plates 622-1 and 622-2.

The upper ends of the composite support plates 624 may bend toward the first deposition nozzles 623-1 and the second deposition nozzles 623-2. In an embodiment, the upper end of the composite support plate 624 disposed on a first side (or the left side in FIG. 10), in the first direction D1, of the first cover plate 622-1 may bend toward a second side (or the right side in FIG. 10), in the first direction D1, of the first cover plate 622-1, and the upper end of the composite support plate 624 disposed on a second side (or the right side in FIG. 10), in the first direction D1, of the second cover plate 622-2 may bend toward a first side (or the left side in FIG. 10), in the first direction D1, of the second cover plate 622-2.

The composite angle limiters 625 may restrict the emission angle of the first deposition material discharged from the first deposition nozzles 623-1 and the emission angle of the second deposition material discharged from the second deposition nozzles 623-2. The composite angle limiters 625 may be supported by the composite support plates 624 to be positioned above the first deposition nozzles 623-1 and the second deposition nozzles 623-2. In an embodiment, the composite angle limiters 625 may be formed in a rectangular box shape and may be disposed between the composite support plate 624 on the first side (or the left side in FIG. 10) of the first cover plate 622-1 and the composite support plate 624 on the second side (or the right side in FIG. 10) of the second cover plate 622-2.

The composite angle-limiting holes 626 may be provided as (or defined by) holes formed at the centers of the composite angle limiters 625. The composite angle-limiting holes 626 may allow some of the first deposition material discharged from the first deposition nozzles 623-1 and some of the second deposition material discharged from the second deposition nozzles 623-2 to pass through while restricting others to limit the emission angles of the first and second deposition materials. In an embodiment, the composite angle-limiting holes 626 may be circular when viewed from above the composite angle limiters 625, but the disclosure is not limited thereto. Alternatively, the composite angle-limiting holes 626 may be provided as square or polygonal holes.

A plurality of composite angle limiters 625 may be provided and may be arranged in the second direction D2 in a way such that the composite angle-limiting holes 626 may be located above (or to overlap) the groups of the first deposition nozzles 623-1 and the second deposition nozzles 623-2.

The connecting plate 627 may be disposed between the first and second cover plates 622-1 and 622-2, connecting the first and second cover plates 622-1 and 622-2 to each other.

An angle α3 between an imaginary line extending from a first side (or the left side in FIG. 10), in the first direction D1, of the first deposition nozzles 623-1 to a first side, in the first direction D1, of the composite angle-limiting holes 626 and an imaginary line extending from the first side of the first deposition nozzles 623-1 parallel to the first cover plate 622-1 may be greater than an angle α4 between an imaginary line extending from the first side of the first deposition nozzles 623-1 to a second side (or the right side in FIG. 10) of the composite angle-limiting holes 626 and an imaginary line extending from the first side of the first deposition nozzles 623-1 parallel to the first cover plate 622-1.

Additionally, the angle α3 may be about 80° or greater. Also, the angle α4 may be about 80° or greater.

Similarly, an angle α6 between an imaginary line extending from a second side (or the right side in FIG. 10), in the first direction D1, of the second deposition nozzles 623-2 to a second side, in the first direction D1, of the composite angle-limiting holes 626 and an imaginary line extending from the second side of the second deposition nozzles 623-2 parallel to the second cover plate 622-2 may be greater than an angle α5 between an imaginary line extending from the second side of the second deposition nozzles 623-2 to the first side (left side in FIG. 10) of the composite angle-limiting holes 626 and an imaginary line extending from the second side of the second deposition nozzles 623-2 parallel to the second cover plate 622-2.

Additionally, the angle α6 may be about 80° or greater. Also, the angle α5 may be about 80° or greater.

The deposition source 600 may be provided as including an individual deposition source 610 that discharges a single type of deposition material and a composite deposition source 620 that discharges multiple different types of deposition materials.

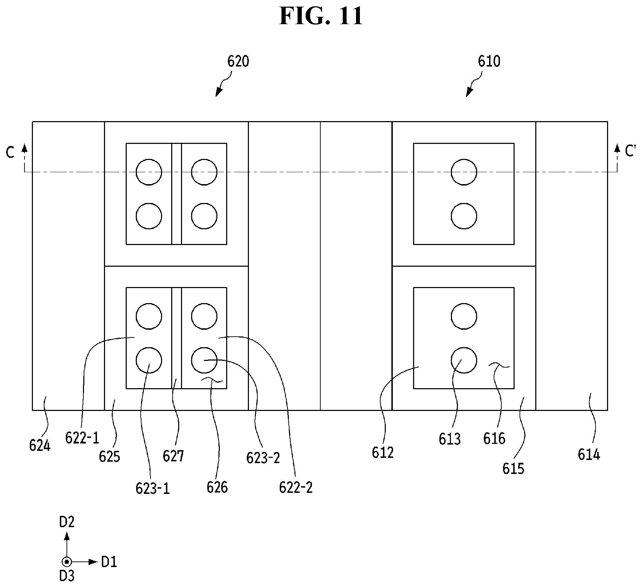

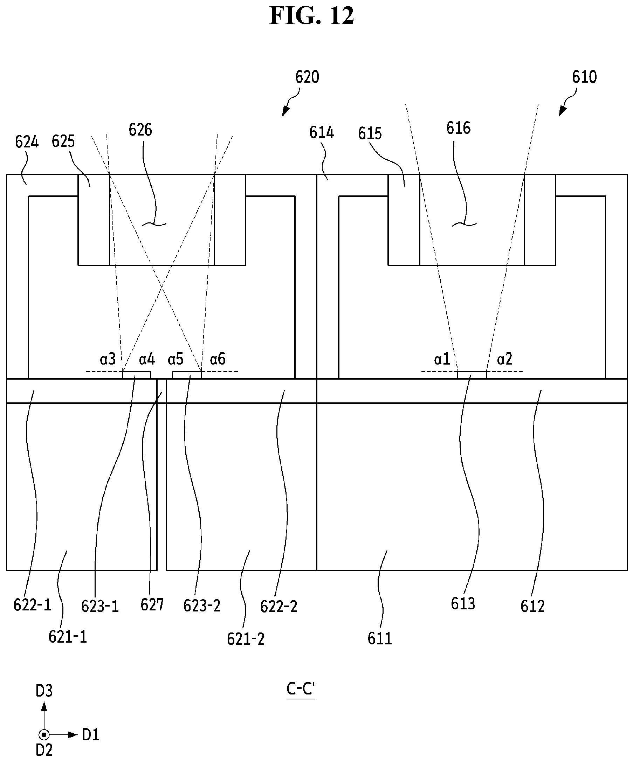

FIG. 11 is a plan view illustrating an embodiment where the deposition source 600 of FIG. 1 is provided as including both the individual deposition source 610 and the composite deposition source 620. FIG. 12 is a cross-sectional view taken along line C-C' of FIG. 11.

Referring to FIGS. 11 and 12, in an embodiment, the individual deposition source 610 may include an individual crucible 611, an individual cover plate 612, individual deposition nozzles 613, individual support plates 614, individual angle limiters 615, and individual angle-limiting holes 616.

The individual crucible 611 may accommodate a deposition material. In other words, the individual crucible 611 may include an accommodation space for containing the deposition material, and the deposition material may be housed in the accommodation space. A plurality of partition walls (not illustrated) may be arranged within the individual crucible 611 to prevent the deposition material from being stored biased toward one direction. Additionally, a separate heater (not illustrated) for vaporizing the deposition material may be disposed inside the individual crucible 611. The individual crucible 611 may have a shape with an open top.

The individual crucible 611 may include or be formed of a material characterized by a low coefficient of thermal expansion at high temperatures. In an embodiment, the individual crucible 611 may include or be formed of a materials such as Cr, Mo, Pt, W, or Ti, but the material of the individual crucible 611 is not particularly limited as long as it has a low coefficient of thermal expansion at high temperatures.

The deposition material contained in the individual crucible 611 may be an organic material for forming an organic light-emitting layer. The deposition material may be an organic material for forming a hole injection layer, hole transport layer, electron transport layer, or electron injection layer, but the disclosure is not limited thereto. That is, various materials may be applied as the deposition material.

The individual cover plate 612 may cover the open top of the individual crucible 611. The individual cover plate 612 may be provided as a plate with a predetermined thickness in the third direction D3. The individual cover plate 612 may be formed to match the size of the open top of the individual crucible 611, to close the open top of the individual crucible 611.

The individual deposition nozzles 613 may be disposed on the upper surface of the individual cover plate 612 and may discharge the deposition material contained in the individual crucible 611 in the third direction D3. The individual deposition nozzles 613 may be formed to communicate with the internal accommodation space of the individual crucible 611, allowing the vaporized deposition material inside the individual crucible 611 to be discharged through the individual deposition nozzles 613 in the third direction D3.

A plurality of individual deposition nozzles 613 may be provided. The individual deposition nozzles 613 may be arranged to be spaced apart from one another in the second direction D2. The individual deposition nozzles 613 may be divided into multiple groups, and the distance between the individual deposition nozzles 613 in each of the groups may be smaller than the distance between the groups. **In** other words, the individual deposition nozzles 613 may be spaced apart from one another by a predetermined distance to form the groups, and the groups may be arranged to be spaced apart from one another by a greater distance than the predetermined distance between the individual deposition nozzles 613 in each of the groups.

The individual support plates 614 may extend in the third direction D3 from the individual cover plate 612. A plurality of individual support plates 614 may be provided and may be disposed on both sides (i.e., left and right sides in FIG. 12), in the first direction D1, of the individual cover plate 612.

The individual support plates 614 may be provided as plates with a predetermined thickness in the first direction D1. The individual support plates 614 may extend along the second direction D2 from both sides, in the first direction D1, of the individual cover plate 612.

The upper ends of the individual support plates 614 may bend toward the center of the individual cover plate 612. In an embodiment, the upper end of the individual support plate 614 disposed on a first side (or the left side in FIG. 12), in the first direction D1, of the individual cover plate 612 may bend toward a second side (or the right side in FIG. 12), in the first direction D1, of the individual cover plate 612, and the upper end of the individual support plate 614 disposed on the second side (or the right side in FIG. 12) of the individual cover plate 612 may bend toward the first side (or the left side in FIG. 12) of the individual cover plate 612.

The individual angle limiters 615 may restrict the emission angle of the deposition material discharged from the individual deposition nozzles 613. The individual angle limiters 615 may be supported by the individual support plates 614 to be positioned above the individual deposition nozzles 613. In an embodiment, the individual angle limiters 615 may be formed in a rectangular box shape and may be disposed between the individual support plate 614 on the first side (or the left side in FIG. 12) of the individual cover plate 612 and the individual support plate 614 on the second side (or the right side in FIG. 12) of the individual cover plate 612.

The individual angle-limiting holes 616 may be provided as holes formed at the centers of the individual angle limiters 615. The individual angle-limiting holes 616 may allow some of the deposition material discharged from the individual deposition nozzles 613 to pass through while restricting some of the deposition material to limit the emission angle of the deposition material. In an embodiment, the individual angle-limiting holes 616 may be rectangular in a plan view or when viewed from above the individual angle limiters 615 in the third direction D3, but the disclosure is not limited thereto. Alternatively, the individual angle-limiting holes 616 may be provided as circular or polygonal holes.

A plurality of individual angle limiters 615 may be provided and may be arranged in the second direction D2 in a way such that the individual angle-limiting holes 616 may be located above (or to overlap) the groups of the individual deposition nozzles 613.

When an imaginary line extending from a first side (or the left side in FIG. 12), in the first direction D1, of the individual deposition nozzles 613 to the top of the individual angle-limiting holes 616 is referred to as a first line, and an imaginary line extending from the first side of the individual deposition nozzles 613 to a point where an imaginary line extending from a first side, in the first direction D1, of the individual angle-limiting holes 616 to the individual cover plate 612 and an imaginary line extending from the first side of the individual deposition nozzles 613 parallel to the individual cover plate 612 meet each other is referred to as a second line, the first line may be longer than the second line. The first line may be perpendicular to the individual cover plate 612, and the second line may be parallel to the individual cover plate 612. Furthermore, the first line may be at least five times longer than the second line.

When an imaginary line extending from the first side of the individual deposition nozzles 613 to the first side of the individual angle-limiting holes 616 is referred to as the third line, an angle α1 between the third line and the second line may be about 80° or greater.

When an imaginary line extending from a second side (or the right side in FIG. 12), in the first direction D1, of the individual deposition nozzles 613 to the top of the individual angle-limiting holes 616 is referred to as a fourth line, and an imaginary line extending from the second side of the individual deposition nozzles 613 to a point where an imaginary line extending from a second side, in the first direction D1, of the individual angle-limiting holes 616 to the individual cover plate 612 and an imaginary line extending from the second side of the individual deposition nozzles 613 parallel to the individual cover plate 612 meet each other is referred to as a fifth line, the fourth line may be longer than the fifth line. The fourth line may be perpendicular to the individual cover plate 612, and the fifth line may be parallel to the individual cover plate 612. Furthermore, the fourth line may be at least five times longer than fifth line.

When an imaginary line extending from the second side (or the right side in FIG. 12) of the individual deposition nozzles 613 to the second side of the individual angle-limiting holes 616 is referred to as a sixth line, an angle α2 between the sixth line and the fifth line may be about 80° or greater.

The composite deposition source 620 may be disposed to be spaced apart from a first side (e.g., the left side in FIG. 12), in the first direction D1, of the individual deposition source 610. The composite deposition source 620 may include a first crucible 621-1, a second crucible 621-2, a first cover plate 622-1, a second cover plate 622-2, first deposition nozzles 623-1, second deposition nozzles 623-2, composite support plates 624, composite angle limiters 625, composite angle-limiting holes 626, and a connecting plate 627.

The first crucible 621-1 may accommodate a first deposition material. In other words, the first crucible 621-1 may include an accommodation space for containing the first deposition material, and the first deposition material may be housed in the accommodation space. A plurality of partition walls (not illustrated) may be arranged within the first crucible 621-1 to prevent the first deposition material from being stored biased toward one direction. Additionally, a separate heater (not illustrated) for vaporizing the first deposition material may be disposed inside the first crucible 621-1. The first crucible 621-1 may have a shape with an open top.

The second crucible 621-2 may be spaced apart from the first crucible 621-1 in the first direction D1. The second crucible 621-2 may accommodate a second deposition material. In other words, the second crucible 621-2 may include an accommodation space for containing the second deposition material, and the second deposition material may be housed in this accommodation space. The second deposition material may be of a different type from the first deposition material. A plurality of partition walls (not illustrated) may be arranged within the second crucible 621-2 to prevent the second deposition material from being stored biased toward one direction. Additionally, a separate heater (not illustrated) for vaporizing the second deposition material may be disposed inside the second crucible 621-2. The second crucible 621-2 may have a shape with its top open.

The first and second crucibles 621-1 and 621-2 may include or be formed of a material characterized by a low coefficient of thermal expansion at high temperatures. In an embodiment, the first and second crucibles 621-1 and 621-2 may include or be formed of a material such as Cr, Mo, Pt, W, or Ti, but the material of the crucibles is not particularly limited as long as it has a low coefficient of thermal expansion at high temperatures.

The first and second deposition materials housed in the first and second crucibles 621-1 and 621-2, respectively, may be organic materials for forming an organic light-emitting layer. The first and second deposition materials may be organic materials for forming a hole injection layer, a hole transport layer, an electron transport layer, or an electron injection layer, but the disclosure is not limited thereto. That is, various materials may be applied as the first and second deposition materials. The first and second deposition materials may be of different types from the deposition material contained in the individual crucible 611.

The first cover plate 622-1 may cover the open top of the first crucible 621-1. The first cover plate 622-1 may be provided as a plate with a predetermined thickness in the third direction D3. The first cover plate 622-1 may be formed to match the size of the open top of the first crucible 621-1, to close the open top of the first crucible 621-1.

The second cover plate 622-2 may cover the open top of the second crucible 621-2. The second cover plate 622-2 may be provided as a plate with a predetermined thickness in the third direction D3. The second cover plate 622-2 may be formed to match the size of the open top of the second crucible 621-2, to close the open top of the second crucible 621-2.

The first deposition nozzles 623-1 may be disposed on the upper surface of the first cover plate 622-1 and may discharge the first deposition material contained in the first crucible 621-1 in the third direction D3. The first deposition nozzles 623-1 may be formed to communicate with the internal accommodation space of the first crucible 621-1, thereby allowing the vaporized first deposition material inside the first crucible 621-1 to be discharged through the first deposition nozzles 623-1 in the third direction D3.

A plurality of first deposition nozzles 623-1 may be provided. The first deposition nozzles 623-1 may be arranged to be spaced apart from one another in the second direction D2.

The second deposition nozzles 623-2 may be disposed on the upper surface of the second cover plate 622-2 and may discharge the second deposition material contained in the second crucible 621-2 in the third direction D3. The second deposition nozzles 623-2 may be formed to communicate with the internal accommodation space of the second crucible 621-2, thereby allowing the vaporized second deposition material inside the second crucible 621-2 to be discharged through the second deposition nozzles 623-2 in the third direction D3.

A plurality of second deposition nozzles 623-2 may be provided. The second deposition nozzles 623-2 may be arranged to be spaced apart from one another in the second direction D2.

The first deposition nozzles 623-1 and the second deposition nozzles 623-2 may be divided into multiple groups. The distance between the first deposition nozzles 623-1 and the second deposition nozzles 623-2 in each of the groups may be smaller than the distance between the groups. In other words, the first deposition nozzles 623-1 and the second deposition nozzles 623-2 may be spaced apart from one another by a predetermined distance to form the groups, and the groups may be arranged to be spaced apart from one another by a greater distance than the predetermined distance between the first deposition nozzles 623-1 and the second deposition nozzles 623-2 in each of the groups. Each of the groups may be composed of a combination of the first deposition nozzles 623-1 and the second deposition nozzles 623-2.

The composite support plates 624 may extend in the third direction D3 from the first and second cover plates 622-1 and 622-2. A plurality of composite support plates 624 may be provided and may be disposed on both sides, in the first direction D1, of the first and second cover plates 622-1 and 622-2 (i.e., left and right sides in FIG. 12).

The composite support plates 624 may be provided as plates with a predetermined thickness in the first direction D1. The composite support plates 624 may extend along the second direction D2 from both sides, in the first direction D1, of the first and second cover plates 622-1 and 622-2.

The upper ends of the composite support plates 624 may bend toward the first deposition nozzles 623-1 and the second deposition nozzles 623-2. In an embodiment, the upper end of the composite support plate 624 disposed on a first side (or the left side in FIG. 12), in the first direction D1, of the first cover plate 622-1 may bend toward a second side (or the right side in FIG. 12), in the first direction D1, of the first cover plate 622-1, and the upper end of the composite support plate 624 disposed on a second side (or the right side in FIG. 12), in the first direction D1, of the second cover plate 622-2 may bend toward a first side (or the left side in FIG. 12), in the first direction D1, of the second cover plate 622-2.

The composite angle limiters 625 may restrict the emission angle of the first deposition material discharged from the first deposition nozzles 623-1 and the emission angle of the second deposition material discharged from the second deposition nozzles 623-2. The composite angle limiters 625 may be supported by the composite support plates 624 to be positioned above the first deposition nozzles 623-1 and the second deposition nozzles 623-2. In an embodiment, the composite angle limiters 625 may be formed in a rectangular box shape and may be disposed between the composite support plate 624 on the first side (or the left side in FIG. 12) of the first cover plate 622-1 and the composite support plate 624 on the second side (or the right side in FIG. 12) of the second cover plate 622-2.

The composite angle-limiting holes 626 may be provided as (or defined by) holes formed at the centers of the composite angle limiters 625. The composite angle-limiting holes 626 may allow some of the first deposition material discharged from the first deposition nozzles 623-1 and some of the second deposition material discharged from the second deposition nozzles 623-2 to pass through while restricting others to limit the emission angles of the first and second deposition materials. In an embodiment, the composite angle-limiting holes 626 may be rectangular when viewed from above the composite angle limiters 625, but the disclosure is not limited thereto. Alternatively, the composite angle-limiting holes 626 may be provided as circular or polygonal holes.

A plurality of composite angle limiters 625 may be provided and may be arranged in the second direction D2 in a way such that the composite angle-limiting holes 626 may be located above (or to overlap) the groups of the first deposition nozzles 623-1 and the second deposition nozzles 623-2.

The connecting plate 627 may be disposed between the first and second cover plates 622-1 and 622-2, connecting the first and second cover plates 622-1 and 622-2 to each other.

An angle α3 between an imaginary line extending from a first side (or the left side in FIG. 12), in the first direction D1, of the first deposition nozzles 623-1 to a first side, in the first direction D1, of the composite angle-limiting holes 626 and an imaginary line extending from the first side of the first deposition nozzles 623-1 in parallel to the first cover plate 622-1 may be greater than an angle α4 between an imaginary line extending from the first side of the first deposition nozzles 623-1 to a second side (or the right side in FIG. 12) of the composite angle-limiting holes 626 and an imaginary line extending from the first side of the first deposition nozzles 623-1 in parallel to the first cover plate 622-1.

Additionally, the angle α3 may be about 80° or greater. Also, the angle α4 may be about 80° or greater.

Similarly, an angle α6 between an imaginary line extending from a second side (or the right side in FIG. 12), in the first direction D1, of the second deposition nozzles 623-2 to a second side, in the first direction D1, of the composite angle-limiting holes 626 and an imaginary line extending from the second side of the second deposition nozzles 623-2 in parallel to the second cover plate 622-2 may be greater than an angle α5 between an imaginary line extending from the second side of the second deposition nozzles 623-2 to the first side (left side in FIG. 12) of the composite angle-limiting holes 626 and an imaginary line extending from the second side of the second deposition nozzles 623-2 in parallel to the second cover plate 622-2.

Additionally, the angle α6 may be about 80° or greater. Also, the angle α5 may be about 80° or greater.

The individual deposition source 610 and the composite deposition source 620 may be operated separately. In an embodiment, for example, when depositing only one type of deposition material onto a deposition substrate SUB, only the individual deposition source 610 may be activated while the composite deposition source 620 remains inactive, thus allowing the deposition of the deposition material onto the deposition substrate SUB. In such an embodiment, when depositing both the first and second deposition materials onto the deposition substrate SUB simultaneously, only the composite deposition source 620 may be activated while the individual deposition source 610 remains inactive, thus enabling the simultaneous deposition of both the first and second deposition materials onto the deposition substrate SUB.

In an embodiment, separate shutters (not illustrated) may be disposed on the individual angle-limiting holes 616 of the individual deposition source 610 and the composite angle-limiting holes 626 of the composite deposition source 620. In such an embodiment, when only the individual deposition source 610 is desired to be operated, the shutters on the composite angle-limiting holes 626 may close the composite angle-limiting holes 626. In such an embodiment, when only the composite deposition source 620 is desired to be operated, the shutters on the individual angle-limiting holes 616 may close the individual angle-limiting holes 616.

The invention should not be construed as being limited to the embodiments set forth herein. Rather, these embodiments are provided so that this disclosure will be thorough and complete and will fully convey the concept of the invention to those skilled in the art.

While the invention has been particularly shown and described with reference to embodiments thereof, it will be understood by those of ordinary skill in the art that various changes in form and details may be made therein without departing from the scope of the invention as defined by the following claims.

## Claims

1. A deposition source comprising:
a crucible configured to accommodate a deposition material and having an open top;
a cover plate covering the open top of the crucible;
a deposition nozzle disposed on an upper surface of the cover plate, wherein the deposition nozzle is configured to discharge the deposition material;
a support plate extending upwardly from the cover plate; and
an angle limiter disposed on the support plate, wherein the angle limiter is configured to restrict an emission angle of the deposition material discharged from the deposition nozzle,
wherein
an angle-limiting hole, through which the deposition material is configured to pass, is defined in the angle limiter, and
a first line extending from one side of the deposition nozzle in a first direction to a top of the angle-limiting hole is longer than a second line extending from the one side of the deposition nozzle in the first direction to a point where an imaginary line extending from one side of the angle-limiting hole in the first direction to the cover plate and an imaginary line extending from the one side of the deposition nozzle in the first direction parallel to the cover plate meet each other.

2. The deposition source of claim 1, wherein
the first line is perpendicular to the cover plate, and
the second line is parallel to the cover plate.

3. The deposition source of claim 1 or claim 2, wherein the first line is at least five times longer than the second line.

4. The deposition source of any one of claims 1 to 3, wherein an angle between the second line and a third line extending from the one side of the deposition nozzle in the first direction to the one side of the angle-limiting hole in the first direction is about 80° or greater.

5. The deposition source of any one of claims 1 to 4, wherein
the deposition nozzle is provided in plural, and
a plurality of deposition nozzles is arranged in a second direction intersecting the first direction.

6. The deposition source according to claim 5, wherein
the plurality of deposition nozzles are divided into multiple groups, and
a distance between the plurality of deposition nozzles in each of the multiple groups is smaller than a distance between adjacent groups among the multiple groups, optionally wherein
the angle limiter is provided in plural, and
a plurality of angle limiters is arranged in the second direction in a way such that angle-limiting holes of the plurality of angle limiters are located above the multiple groups.

7. A deposition source comprising:
a crucible configured to accommodate a deposition material and having an open top;
a cover plate covering the open top of the crucible;
a deposition nozzle disposed on an upper surface of the cover plate, wherein the deposition nozzle is configured to discharge the deposition material;
a support plate extending upwardly from the cover plate; and
an angle limiter disposed on the support plate, wherein the angle limiter is configured to restrict an emission angle of the deposition material discharged from the deposition nozzle,
wherein
an angle-limiting hole, through which the deposition material is configured to pass, is defined in the angle limiter, and
an angle between an imaginary line extending from one side of the deposition nozzle in a first direction to one side of the angle-limiting hole in the first direction and an imaginary line parallel to the cover plate is greater than an angle between an imaginary line extending from the one side of the deposition nozzle in the first direction to an opposite side of the angle-limiting hole in the first direction and the imaginary line parallel to the cover plate.

8. The deposition source according to claim 7, wherein:
(i) the angle between the imaginary line extending from the one side of the deposition nozzle in the first direction to the one side of the angle-limiting hole in the first direction and the imaginary line parallel to the cover plate is about 80° or greater; and/or
(ii) the angle between the imaginary line extending from the one side of the deposition nozzle in the first direction to the opposite side of the angle-limiting hole in the first direction and the imaginary line parallel to the cover plate is about 80° or greater.

9. The deposition source of claim 7 or claim 8, wherein
the deposition nozzle is provided in plural, and
a plurality of deposition nozzles are arranged in the first direction and a second direction intersecting the first direction.

10. The deposition source of claim 9, wherein
the plurality of deposition nozzles are divided into multiple groups, and
a distance between the plurality of deposition nozzles in each of the multiple groups is smaller than a distance between adjacent groups among the multiple groups, optionally wherein
the angle limiter is provided in plural, and
a plurality of angle limiters is arranged in the second direction in a way such that angle-limiting holes of the plurality of angle limiters are located above the groups.

11. The deposition source of claim 9 or claim 10, wherein
the crucible is provided in plural, and
a plurality of crucibles includes a first crucible configured to accommodate a first deposition material and a second crucible spaced apart from the first crucible in the first direction and configured to accommodate a second deposition material, optionally wherein the plurality of deposition nozzles includes first deposition nozzles arranged in the second direction on the first crucible and second deposition nozzles arranged in the second direction on the second crucible.

12. A deposition apparatus comprising:
a chamber;
a substrate holder disposed inside the chamber, wherein the substrate holder is configured to support a substrate;
a mask assembly disposed below where the substrate is configured to be supported; and
a deposition source which is configured to discharge a deposition material to the mask assembly,
wherein the deposition source includes an individual deposition source, and a composite deposition source spaced apart from the individual deposition source in a first direction, wherein the individual deposition source is configured to discharge a single type of the deposition material and the composite deposition source is configured to discharge multiple different types of the deposition material.

13. The deposition apparatus of claim 12, wherein
the individual deposition source includes: an individual crucible configured to accommodate the deposition material and having an open top; an individual cover plate covering the open top of the individual crucible; an individual deposition nozzle disposed on an upper surface of the individual cover plate, wherein the individual deposition nozzle is configured to discharge the deposition material; and an individual angle limiter disposed above the individual deposition nozzle, wherein an individual angle-limiting hole, through which the deposition material is configured to pass, is defined in the individual angle limiter, and
the composite deposition source includes: a first crucible configured to accommodate a first deposition material and having an open top; a second crucible configured to accommodate a second deposition material and having an open top; a first cover plate covering the open top of the first crucible; a second cover plate covering the open top of the second crucible; a first deposition nozzle disposed on an upper surface of the first cover plate, wherein the first deposition nozzle is configured to discharge the first deposition material; a second deposition nozzle disposed on an upper surface of the second cover plate, wherein the second deposition nozzle is configured to discharge the second deposition material; and a composite angle limiter disposed above the first and second deposition nozzles, wherein a composite angle-limiting hole, through which the first and second deposition materials are configured to pass, is defined in the composite angle limiter.

14. The deposition apparatus of claim 13, wherein an angle between an imaginary line extending from one side of the individual deposition nozzle in the first direction to one side of the individual angle-limiting hole in the first direction and an imaginary line parallel to the individual cover plate is about 80° or greater.

15. The deposition apparatus of claim 13 or claim 14, wherein an angle between an imaginary line extending from one side of the first deposition nozzle in the first direction to one side of the composite angle-limiting hole in the first direction and an imaginary line parallel to the first cover plate is greater than an angle between an imaginary line extending from the one side of the first deposition nozzle in the first direction to an opposite side of the composite angle-limiting hole in the first direction and the imaginary line parallel to the first cover plate.

16. The deposition apparatus of claim 15, wherein:
(i) the angle between the imaginary line extending from the one side of the first deposition nozzle in the first direction to the one side of the composite angle-limiting hole in the first direction and the imaginary line parallel to the first cover plate is about 80° or greater; and/or
(ii) the angle between the imaginary line extending from the one side of the first deposition nozzle in the first direction to the opposite side of the composite angle-limiting hole in the first direction and the imaginary line parallel to the first cover plate is about 80° or greater.

17. The deposition apparatus of any one of claims 13 to 16, wherein an angle between an imaginary line extending from an opposite side of the second deposition nozzle in the first direction to an opposite side of the composite angle-limiting hole in the first direction and an imaginary line parallel to the second cover plate is greater than an angle between an imaginary line extending from the opposite side of the second deposition nozzle in the first direction to one side of the composite angle-limiting hole in the first direction and the imaginary line parallel to the second cover plate.

18. The deposition apparatus of claim 17, wherein:
(i) the angle between the imaginary line extending from the opposite side of the second deposition nozzle in the first direction to the opposite side of the composite angle-limiting hole in the first direction and the imaginary line parallel to the second cover plate is about 80° or greater; and/or
(ii) the angle between the imaginary line extending from the opposite side of the second deposition nozzle in the first direction to the one side of the composite angle-limiting hole in the first direction and the imaginary line parallel to the second cover plate is about 80° or greater.

19. An electronic device comprising:
a display device manufactured by a deposition apparatus;
the deposition apparatus comprising:
a chamber;
a substrate holder disposed inside the chamber, wherein the substrate holder is configured to support a substrate;
a mask assembly disposed below where the substrate is configured to be supported; and
a deposition source which is configured to discharge a deposition material to the mask assembly,
wherein the deposition source includes an individual deposition source, and a composite deposition source spaced apart from the individual deposition source in a first direction, wherein the individual deposition source is configured to discharge a single type of the deposition material and the composite deposition source is configured to discharge multiple different types of the deposition material.
